Europäisches Patentamt

European Patent Office

Office européen des brevets

(11) Publication number: **0 055 573**

**B1**

# EUROPEAN PATENT SPECIFICATION

(45) Date of publication of patent specification: **19.06.85**

(51) Int. Cl.⁴: **H 03 K 5/22**

(21) Application number: **81305985.4**

(22) Date of filing: **21.12.81**

(54) **Comparator circuit.**

(30) Priority: **26.12.80 JP 188936/80**

(43) Date of publication of application:
**07.07.82 Bulletin 82/27**

(45) Publication of the grant of the patent:
**19.06.85 Bulletin 85/25**

(84) Designated Contracting States:
**DE FR GB NL**

(56) References cited:
US-A-3 569 739
US-A-3 628 059
US-A-3 760 195
US-A-3 816 761
US-A-3 848 139
US-A-3 890 575

(73) Proprietor: **FUJITSU LIMITED**
**1015, Kamikodanaka Nakahara-ku**
**Kawasaki-shi Kanagawa 211 (JP)**

(72) Inventor: **Ide, Tetsuo**
**33-20, Sumiregaoka Kohoku-ku**
**Yokohama-shi Kanagawa 223 (JP)**
Inventor: **Iwamoto, Hiromu**
**31-2-308, Hiragata-cho Kanazawa-ku**
**Yokohama-shi Kanagawa 236 (JP)**

(74) Representative: **Billington, Lawrence Emlyn**
**et al**
**HASELTINE LAKE & CO Hazlitt House 28**
**Southampton Buildings Chancery Lane**
**London WC2A 1AT (GB)**

## Description

This invention relates to a comparator circuit.

When providing a comparator circuit by an IC and giving a hysteresis characteristic to the comparator circuit, the hysteresis width is determined normally in dependence upon power supply voltage and resistance ratio. In addition, in the case of an integrated circuit which can set from outside the power supply current and bias current, such as a low power integrated circuit, such hysteresis width is determined by said current or internal resistance. The power supply voltage is usually comparatively constant but in some cases changes considerably.

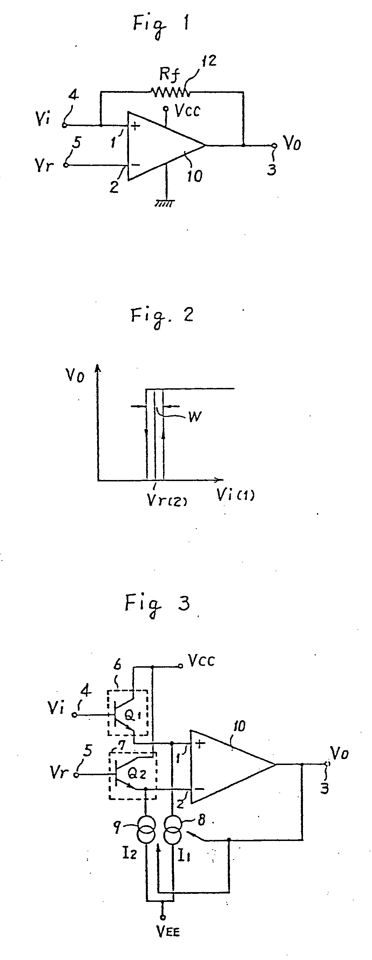

Figure 1 shows the structure of an existing ordinary comparator circuit. In Fig. 1, 10 is a high gain differential amplifier having an input terminal (positive side) 1, reference terminal 2 (negative side) and output terminal 3, and its input terminal 1 is connected to the input voltage terminal 4, while the reference terminal 2 is connected to the reference voltage terminal 5. To the input voltage terminal 4, an input voltage $V_i$ is applied while to the reference voltage terminal 5, the reference voltage $V_r$ is applied. When $V_i(1) < V_r(2)$; where $V_i(1)$ is an input voltage at the input terminal 1 and $V_R(2)$ is the reference voltage at the reference terminal 2, the differential amplifier 10 outputs an output voltage $V_0$ of L (low) level to the output terminal 3, and when $V_i(1) > V_r(2)$, an output voltage $V_0$ of H (high) level is provided. A proportional operation area of the amplifier occurs in the vicinity where $V_i(1) = V_r(2)$, but when the gain is high such an operation area is very narrow and $V_0$ is considered to change in the form of a step when $V_i(1) = V_r(2)$, as shown in Fig. 2.

When an output voltage $V_0$ is fed back to the input terminal 1 of such differential amplifier 10 via the resistor 12 ($R_f$), the hysteresis characteristic having the width W is obtained as shown in Fig. 2. In Fig. 1, the input voltage terminal 4 to which an input voltage $V_i$ is applied has an input resistance $R_{in}$ ($R_{in} < R_f$) but it is omitted in the drawing.

In Fig. 1, if an output voltage $V_0$ becomes H (high) level, for example, an input voltage $V_i(1)$ is boosted by such H level. Therefore, $V_0$ does not become L (low), because the relation $V_i(1) < V_r(2)$ is not established if an input voltage $V_i(4)$ is not lowered by the boost amount or more. In addition, when an output voltage $V_0$ changes to H from L, an output voltage $V_0$ becomes H only when an input voltage $V_i(1)$ is lowered by means of the feedback resistance 12 and resultingly $V_i(4)$ becomes higher than that when the feedback resistance 12 is not used.

The hysteresis width W of the comparator circuit having such hysteresis characteristic is influenced by the power supply voltage $V_{cc}$. Namely, the H level output voltage $V_0$ is determined by the power supply voltage $V_{cc}$ and becomes small when the power supply voltage is lowered. Therefore, the circuit shown in Fig. 1 has a disadvantage that a value of input voltage $V_i(4)$

which changes from H level to L or from L level to H causes the hysteresis width W to change also.

A preferred embodiment of the present invention provides a comparator circuit which does not allow the hysteresis width to change due to a change of power supply voltage.

A preferred embodiment moreover provides a comparator circuit which is capable of sustaining a constant hysteresis width without requiring a change of constant of external elements even when the power supply voltage or power source current is change in the range of several times rated value.

According to the present invention there is provided a comparator circuit operatively connected to receive input and reference voltages and comprising:

a differential amplifier including an input terminal, a reference terminal and an output terminal;

an input voltage terminal to which the input voltage is applied; and

a reference voltage terminal to which the reference voltage is applied; characterized by:

first level shift means operatively connected between said input voltage terminal and said input terminal, or between said reference voltage terminal and said reference terminal, for shifting the level of the input voltage or the reference voltage to provide hysteresis which is substantially independent of power supply voltage; said first level shift means comprising a diode or a base-emitter path of a transistor;

first current source means operatively connected to said first level shift means for supplying current to said first level shift means; and control means operatively connected to said first current source means and said output terminal for controlling the current value of said current source means in accordance with the output level of said output terminal.

For a better understanding of the invention, and to show how it may be put into effect, reference will now be made by way of example to the accompanying drawings in which:

Figure 1 shows the structure of an existing comparator circuit;

Figure 2 shows the hysteresis characteristic of the circuit shown in Figure 1;

Figure 3 shows the structure of a comparator circuit according to a first embodiment of the present invention;

Figure 4 is the structure of a comparator circuit according to a second embodiment of the present invention;

Figure 5 is the structure of a comparator circuit according to a third embodiment of the present invention;

Figure 6 is an example of a practical circuit corresponding to the embodiment of Figure 3; and

Figure 7 is another example of a practical circuit corresponding to the embodiment of Figure 3.

Figure 3 shows the structure of a comparator circuit according to a first embodiment of the present invention. In Figure 3 the same portions as those in Figure 1 are given the same numbering. In the circuit of Figure 3, a level shift means 6 comprising the base-emitter path of a transistor $Q_1$ is provided between the input terminal 1 and input voltage terminal 4 of differential amplifier 10, and a level shift means 7 comprising the base-emitter path of a transistor $Q_2$ is provided between the reference terminal 2 and reference voltage terminal 5 of differential amplifier 10, $V_{CC}$, $V_{EE}$ are respectively the high and low voltage power supplies.

The emitter follower type transistors $Q_1$, $Q_2$ are driven by a constant current by the current sources 8, 9 so that an input current can be ignored. These currents $I_1$, $I_2$ are given by the following equations.

$$I_1 \fallingdotseq I_s e^{q/kT \cdot V_{BE1}} \qquad (1)$$

$$I_2 \fallingdotseq I_s e^{q/kT \cdot V_{BE2}} \qquad (2)$$

Here, $I_s$ is the saturation current, q is the charge of electron, k is the Boltzman's constant, T is the absolute temperature, $V_{BE1}$, $V_{BE2}$ are the base emitter voltage of transistors $Q_1$, $Q_2$.

From the equations (1) and (2),

$$V_{BE1} = kT/q \, 1n I_1/I_s \qquad (3)$$

$$V_{BE2} = kT/q \, 1n I_2/I_s \qquad (4)$$

Therefore:

$$V_{BE2} - V_{BE1} = kT/q \, 1n I_2/I_1 \qquad (5)$$

From the above equation, when $I_1 = I_2$, $V_{BE1} = V_{BE2}$, and when $I_2 = 2I_1$,

$$V_{BE2} - V_{BE1} = (kT/q) 1n2 \fallingdotseq 20 (mV).$$

In the case of this circuit, the current source 9 is allowed, for example, to change and the relation $I_2 = I_1$ is obtained when an output voltage $V_0$ is L level or the relation $I_2 = mI_1$ (here m>1) is obtained when it is H level. Thereby, when an output voltage $V_0 = L$ level and $V_{BE}$ which is the same as that in case $I_2 = I_1$ is added to the input voltage $V_i$ and reference voltage $V_r$. Therefore it becomes equal to zero, considering it from the differential amplifier 10, and an output voltage $V_0$ becomes H level when $V_i > V_r$. When an output voltage $V_0$ becomes H level, the current source 9 outputs $mI_1$ and $V_{BE2}$ becomes large as is obvious from the equation (4) (increment is considered as $\Delta V$). Namely, the reference voltage $V_r$ is supposed to be lowered by $\Delta V$ when considered from the differential amplifier 10. Therefore, a voltage being input to the input terminal 1 of the differential amplifier 10 seems to be relatively increased. For this reason, when an output voltage $V_0$ returns to the L level, an input voltage $V_i$ must be lowered by $\Delta V$ than the reference voltage $V_r$, and thereby an output voltage $V_0$ indicates the hysteresis characteristic having the width of $\Delta V$.

Moreover, the width $\Delta V$, as is obvious from the equation (5), depends on the physical constants such as k, T, q and a current ratio of $I_2/I_1$, but not on the power supply voltage $V_{CC}$. The hysteresis width thus obtained is not influenced by power supply voltage fluctuation. In the case of integrated circuits, resistance values fluctuate considerably but a current ratio of the constant current source can be set accurately to the desired value. Resultingly, the hysteresis width can be adjusted accurately by changing such current ratio.

Since the hysteresis width is determined by a change value m of current of the current source 9, when, m=10 (at this time, said width is about 60mV), a large hysteresis width can be obtained. In addition, when the current source 8 in the input voltage $V_i$ side is increased in the backward direction together with the current source 9, namely when $I_2$ is increased m times, the hysteresis width is doubled compared to that while only one current source is used by changing $I_1$ to $I/m$.

In such a case where only the current source 9 is changed, the level shift means 6 and current source 8 can be omitted. However, in this case, an input voltage $V_i$ is directly applied to the input terminal 1 (without level shift) and therefore when $V_i > V_r - V_{BE2}$, an output voltage $V_0$ turns to the H level from L level.

At any rate, the hysteresis characteristic can be obtained by controlling a constant current value of the current source 8 or 9.

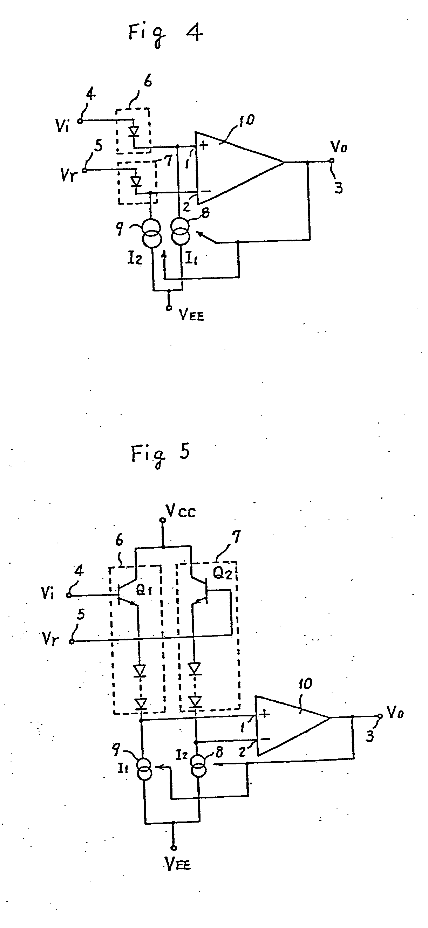

Figure 4 shows the structure of a comparator circuit according to another embodiment of the present invention.

In Fig. 4, as the level shift means 6, 7, diodes are used and other elements are the same as those in Fig. 3.

Figure 5 shows the structure of a comparator circuit according to another embodiment of the present invention.

As shown in Fig. 5, when the level shift means 6, 7 are formed by inserting diodes in series with the emitters of transistors $Q_1$, $Q_2$, an amount of change in the forward diode voltage is added. Therefore, the range of hysteresis width change due to a change of current value of the current source becomes wide. Namely, when values of constant current source are $I_1$, $I_2$ for the L level output voltage $V_0$ and these are changed respectively to $I_1'$, $I_2'$ for the H level output voltage $V_0$,

$$\Delta V = N(kT/q) 1n(I_2/I_1 \cdot I_1'/I_2')$$

when the sum of the transistors and diodes used for level shifts is considered as N for both inputs.

A current value of the constant current source can be done easily, for example, by changing over the two current sources of $I_1$, $mI_1$ prepared with the H and L levels of the output voltage $V_0$.

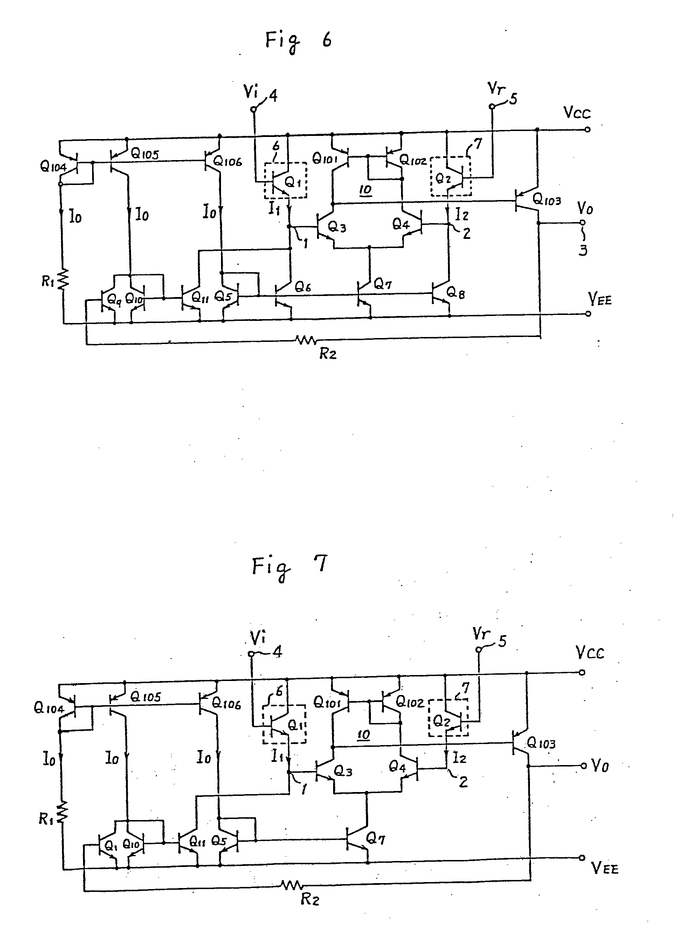

Figure 6 is an example of a practical circuit corresponding to an embodiment of Fig. 3.

In this figure, the transistors $Q_{101}$ to $Q_{103}$, $Q_3$, $Q_4$ and $Q_7$ correspond to the differential amplifier 10,

and $Q_1$, $Q_2$ are input transistors, while $Q_6$, $Q_8$, $Q_{11}$ are current source transistor and these respectively correspond to said level shift means 6, 7 and current sources 8, 9.

The transistors $Q_{104}$ to $Q_{106}$ control the circuit for generating the bias current $I_0$, while the transistors $Q_5$, $Q_9$, $Q_{10}$ control the bias current of differential amplifier 10 with said current. When the output voltage $V_0$ is L level in this case, the transistor $Q_9$ is OFF, and resultingly the bias current $I_1$ of transistor $Q_1$ is two times of $I_0$ and the bias current $I_2$ of transistor $Q_2$ is equal to $I_0$. Therefore, $V_{BE}$ of transistor $Q_1$ and $V_{BE}$ of transistor $Q_2$ are in the following relation.

$$V_{BE1}-V_{BE2}\fallingdotseq 20mV$$

In addition the base potentials $V_1$, $V_2$ of transistors $Q_3$, $Q_4$ are expressed as follows:

$$V_1=V_i-V_{BE1}$$

$$V_2=V_r-V_{BE2}$$

Therefore, a difference of these voltages $V_1$, $V_2$ becomes as follows:

$$V_1-V_2=V_i-V_r-(V_{BE1}-V_{BE2})$$
$$=V_i-(V_r+20mV)$$

When the input voltage $V_i$ changes to H level from L level, the output $V_0$ changes to H level from L level at the point where $V_i=V_r+20mV$. When the output voltage $V_0$ becomes H level, the transistor $Q_9$ turns ON and $I_1=I_2=Ic$.

Thus,

$$V_1-V_2=V_i-V_r.$$

When $V_i$ changes to L level from H level, $V_0$ becomes L level from H level at the point where $V_i=V_r$. Thus, this circuit has the hysteresis width of $\Delta V=20mV$.

Figure 7 shows another practical example. This circuit is different from Fig. 6 in that the current source transistors $Q_6$, $Q_8$ are omitted.

In this circuit, the base current of transistors $Q_3$, $Q_4$ in the next stage is used as the bias current of level shift means 6, 7 and therefore the hysteresis width $\Delta W$ becomes as follows:

$$\Delta W=kT/q1n((1/\beta \cdot I_0/2+I_0)/(1/\beta \cdot I_0/2))$$
$$\fallingdotseq kT/q1n(2\beta)$$

$\beta$ is the current amplification coefficient of the NPN transistors $Q_3$, $Q_4$. When $\beta$ changes within the range from 50 to 250, $\Delta W\fallingdotseq 120$ to $160mV$, resulting in a large hysteresis width. Therefore, the circuit of Fig. 7 is a very effective circuit for a certain purpose.

As explained above, according to the present invention, a comparator circuit having a hysteresis characteristic of accurate width which is not influenced by fluctuation of power source voltage is obtained by the method that the input voltage $V_i$ and/or the reference voltage $V_r$ is shifted by $V_{BE}$ of a transistor and said $V_{BE}$ is changed in accordance with the output level of the comparator circuit.

## Claims

1. A comparator circuit operatively connected to receive input and reference voltages and comprising:
a differential amplifier (10) including an input terminal (1), a reference terminal (2) and an output terminal (3);
an input voltage terminal (4) to which the input voltage is applied; and
a reference voltage terminal (5) to which the reference voltages is applied; characterized by:
first level shift means (6) operatively connected between said input voltage terminal (4) and said input terminal (1), or between said reference voltage terminal (5) and said reference terminal (2), for shifting the level of the input voltage or the reference voltage to provide hysteresis which is substantially independent of power supply voltage, said first level shift means (6) comprising a diode or a base-emitter path of a transistor ($Q_1$);
first current source means (8) operatively connected to said first level shift means (6) for supplying current to said first level shift means (6); and
control means operatively connected to said first current source means (8) and said output terminal (3) for controlling the current value of said current source means (8) in accordance with the output level of said output terminal (3).

2. A comparator circuit as claimed in claim 1, wherein said first level shift means (6) is operatively connected between said input voltage terminal (4) and said input terminal (1), said first current source means (8) being operatively connected to said control means and said first level shift means (6), characterized in that:
said comparator circuit further comprises second level shift means (7) operatively connected between said reference voltage terminal (5) and said reference terminal (2) to provide hysteresis which is substantially independent of power supply voltage, said second level shift means (7) comprising a diode or a base-emitter path of a transistor ($Q_2$), said comparator circuit further comprising second current source means (9) operatively connected to said control means and said second level shift means (7).

## Revendications

1. Circuit comparateur connecté d'une manière opérante pour recevoir des tensions d'entrée et de référence et comprenant:
un amplifacteur différentiel (10) incluant une borne d'entrée (1), borne de référence (2) et une borne de sortie (3);

une borne de tension d'entrée (4) à laquelle est appliquée la tension d'entrée; et

une borne de tension de référence (5) à laquelle est appliquée la tension de référence; caractérisé en ce qu'il comprend:

un premier moyen de décalage de niveau (6) connecté d'une manière opérante entre la borne de tension d'entrée (4) et la borne d'entrée (1), ou entre la borne de tension de référence (5) et la borne de référence (2), pour décaler le niveau de la tension d'entrée ou de la tension de référence pour fournir une hystérésis qui est essentiellement indépendante de la tension d'alimentation, ledit premier moyen de décalage de niveau (6) comprenant une diode ou un chemin de base-émetteur d'un transistor ($Q_1$);

une première source de courant (8) connectée d'une manière opérante au premier moyen de décalage de niveau (6) pour fournir un courant au premier moyen de décalage de niveu (6); et

un moyen de réglage connecté d'une manière opérante à la première source de courant (8) et à la borne de sortie (3) pour régler la valeur de courant de la source de courant (8) selon le niveau de sortie de la borne de sortie (3).

2. Circuit comparateur selon la revendication 1, caractérisé en ce que, le premier moyen de décalage de niveau (6) étant connecté d'une manière opérante entre la borne de tension d'entrée (4) et la borne d'entrée (1), la première source de courant (8) étant connectée d'une manière opérante au moyen de réglage et au premier moyen de décalage de niveau (6), il comprend en outre:

un second moyen de décalage de niveau (7) connecté d'un manière opérante entre la borne de tension de référence (5) et la borne de référence (2) pour fournir une hystérésis qui est essentiellement indépendante de la tension d'alimentation, le second moyen de décalage de niveau (7) comprenant une diode ou un chemin de base-émetteur d'un transistor ($Q_2$); et

une seconde source de courant (9) connectée d'une manière opérante au moyen de réglage et au second moyen de décalage de niveau (7).

**Patentansprüche**

1. Komparator-Schaltkreis, der zum Empfang von Eingangs- und Referenzspannungen angeschlossen ist und umfaßt:

einen Differenzialverstärker (10), der einen Eingangsanschluß (1), einen Referenzanschluß (2) und einen Ausgangsanschluß (3) aufweist;

einen Eingangsspannungsanschluß (4), dem dei Eingangsspannung zugeführt wird; und

einen Referenzspannungsanschluß (5), dem die Referenzspannung zugeführt wird; gekennzeichnet durch

eine erste Pegelschiebeeinrichtung (6), die wirkungs-mäßig zwischen dem genannten Eingangsspannungsanschluß (4) und dem genannten Eingangsanschluß (1) oder zwischen dem genannten Referenzspannungsanschluß (5) und dem genannten Referenzanschluß (2) geschaltet ist, um den Pegel der Eingangsspannung oder der Referenzspannung zu verschieben, um eine Hysterese zu bilden, welche im wesentlichen unabhängig von der Energieversorgungsspannung ist, wobei die erste Pegelschiebeeinrichtung (6) eine Diode oder einen Basis-Emitter-Weg eines Transistors (Q1) umfaßt;

eine erste Stromquelleneinrichtung (8) die wirkungsmäßig mit der genannten Pegelschiebeeinrichtung (6) verbunden ist um der genannten ersten Pegelschiebeeinrichtung (6) einen Strom zuzuführen; und

eine Steuereinrichtung, die wirkungsmäßig mit der genannten ersten Stromquelleneinrichtung (8) und dem genannten Ausgangsanschluß (3) verbunden ist um den Stromwert der genannten Stromquelleneinrichtung (8) in Übereinstimmung mit einem Ausgangspegel des genannten Ausgangsanschlusses (3) zu steuern.

2. Komparator-Schaltung nach Anspruch 1, bei welcher die genannte erste Pegelschiebeeinrichtung (6) wirkungsmäßig zwischen dem genannten Eingangsspannungsanschluß (4) und dem genannten Eingangsanschluß (1) geschaltet ist, wobei die erste Stromquelleneinrichtung (8) wirkungsmäßig mit der genannten Steuereinrichtung und der genannten ersten Pegelschiebeeinrichtung (6) verbunden ist, dadurch gekennzeichnet

daß die Komparator-Schaltung ferner eine zweite Pegelschiebeeinrichtung (7) umfaßt die wirkungsmäßig zwischen den genannten Referenzspannungsanschluß (5) und den genannten Referenzanschluß (2) geschaltet ist, um eine Hysterese zu liefern, welche im wesentlichen unabhängig von der Energieversorgungsspannung ist, wobei die zweite Pegelschiebeeinrichtung (7) eine Diode oder einen Basis-Emitter-Weg eines Transistors umfaßt,

und die genannte Komparator-Schaltung ferner eine zweite Stromquelleneinrichtung (9) umfaßt, welche wirkungsmäßig mit der genannten zweiten Steuereinrichtung und der genannten zweiten Pegelschiebeeinrichtung (7) verbunden ist.

0 055 573

Fig. 1

Fig. 2

Fig. 3

1

Fig 4

Fig 5

## Fig 6

## Fig 7